# EUROPEAN PATENT SPECIFICATION

(11) **EP 0 335 715 B1**
(45) Date of publication and mention of the grant of the patent: **26.07.1995**
(21) Application number: 89303150.0
(22) Date of filing: 30.03.1989
(51) Int. Cl.: G11C 7/00

(54) **Input circuits**
Eingangsschaltungen
Circuits d'entrée

(30) Priority: 31.03.1988 JP 79558/88; 25.07.1988 JP 185995/88
(43) Date of publication of application: 04.10.1989
(73) Proprietor: SONY CORPORATION, Tokyo 141 (JP)
(72) Inventor: Nishino, Yoichi c/o Patents Division, Shinagawa-ku Tokyo 141 (JP)
(74) Representative: Pilch, Adam John Michael

(56) References cited:
- IEEE INT. CONF. ON COMMUNICATIONS 1987 17 June 1974, MINNEAPOLIS, USpages 39 1 - 39 5; G. HANKE: 'PCM receiving equipment of a 640 MBITS/Swaveguide transmission system using integrated circuits'
- ELECTRONICS LETTERS vol. 3, no. 6, June1967,STEVENAGE, GB pages 282 - 283; P.M. CASHIN ET AL.: 'Time-division multiplexer/demultiplexer for digital transmission in the gigabit per second range'
- J.E.E. JOURNAL OF ELECTRONIC ENGINEERING vol. 23, no. 233, May 1986,
- TOKYO, JP pages 66 - 70; A. TEZUKA ET AL.: 'GaAs logic IC enables developmentof ultrahigh-speed optical communications systems'
- BBC RESEARCH DEPARTMENT REPORT no. 5, July 1987, TADWORTH, GBpages 1 - 20; J.L. RILEY: 'A review of the semiconductor storage of televisionsignals: Part 1 Historical introduction and design philosophy'
- TEXAS INSTRUMENTS, Product Review TMS4464, 1984, pages 1-17
- ELEKTRONOK, vol. 31, no. 15, July 1982, München, DE, pages 27-30, P. MATTOS et al.: "Nibble-Mode beschleunigt Speicherzugriff"

## Description

### INPUT CIRCUITS

This invention relates to input circuits such as those suitable for use in memory circuits for storing, for example, image data.

In memory circuits, it has been the practice that input image data is written in a memory element after the transfer rate of the data has been converted to a lower frequency, the data is read out of the memory element at the lower frequency, and the transfer rate is converted to a higher frequency for data output; as a result, positive storage of the image data is ensured even if a memory element of a slower write and read speed is used (NIKKEI ELECTRONICS, 1985.3.11, pp. 219 - 239).

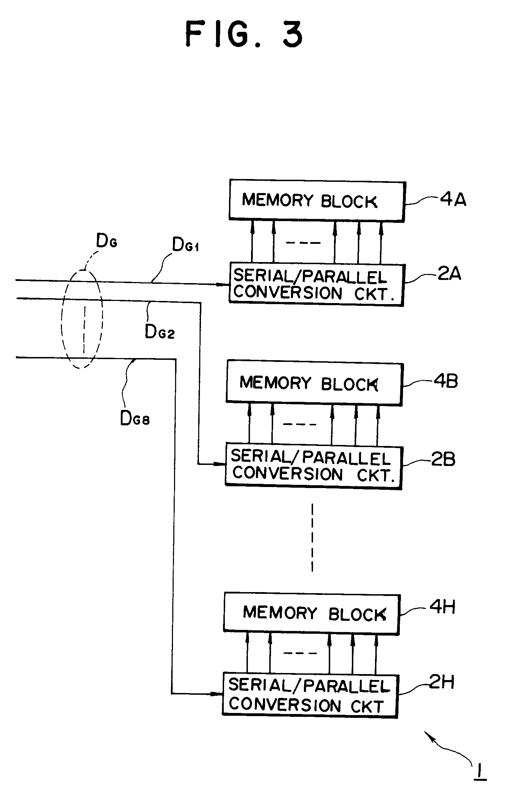

More particularly, referring to Figure 3 of the accompanying drawings, in a memory circuit 1, each one-bit data DG1 to DG8 constituting 8-bit image data DG is supplied to a respective one of serial/parallel conversion circuits 2A to 2H.

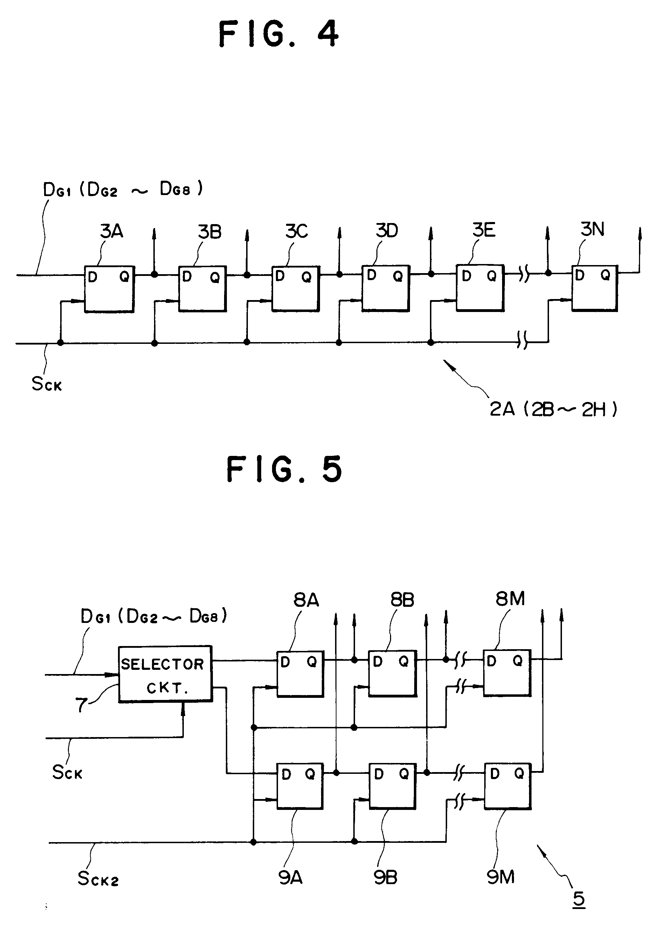

As shown in Figure 4 of the accompanying drawings, each of the serial/parallel conversion circuits 2A to 2H is made up of D flip-flop circuits 3A to 3N of a master-slave type connected in series and arranged to acquire the data at a timing synchronised with a clock signal SCK of the image data DG, the data DG1 to DG8 being supplied to the D flip-flop circuit 3A at one end.

Consequently, the data DG1 to DG8 are each sequentially transferred to the adjoining D flip-flop circuit, from the D flip-flop circuit 3A at one end towards the D flip-flop circuit 3N at the other end, at the timing synchronised with the clock signal SCK. By arranging that the data are entered into memory blocks 4A to 4H (Figure 3) at intervals of predetermined periods of the clock signal SCK, it is possible to write the image data DG into the memory blocks 4A to 4H at a low frequency converted from the transfer rate of the image data DG at a high frequency.

Conversely, by reading out the data from the memory blocks 4A to 4H and supplying the data through the parallel/serial converters, it is possible to read out data at a low frequency and supply the image data DG at a transfer rate converted to a high frequency.

Such input/output circuits using serial/parallel conversion circuits and parallel/serial conversion circuits have the disadvantages that power consumption therein is large and a large instantaneous current is drawn thereby.

More particularly, in such master-slave type D flip-flop circuits formed of CMOS (complementary metal oxide semiconductor) devices, each circuit has a power consumption of tens of »W/MHz/bit.

Further, in practice, when 30 MHz or so of image data is to be positively written in or read out from a memory element, it is necessary to provide 700 or so serially connected D flip-flop circuits for one bit of the image data.

Hence, 700 mW or so of power is consumed for one bit of the image data and this leads to difficulty in arranging the circuit elements in the form of an integrated circuit.

Besides, in a D flip-flop circuit of the above-described type, 0.1 mA or so of instantaneous current flows for each circuit on the leading and trailing edges of the clock signal SCK, and since the D flip-flop circuits constituting an input/output circuit in question operate in synchronism with the clock signal SCK, this has led to the problem that 70 mA or so of instantaneous current flows in total.

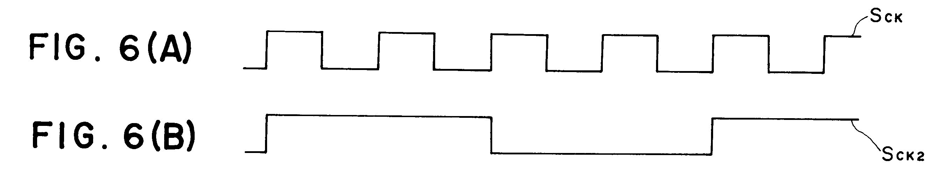

As a means of overcoming this problem, a method using a serial/parallel conversion circuit 5 as shown in Figure 5 of the accompanying drawings has been proposed, Figures 6(A) and 6(B) of the accompanying drawings showing operation of the circuit 5.

In the circuit 5, data DG1 to DG8 are passed through a selector circuit 7, whose contacts are switched over in synchronism with the clock signal SCK (Figure 6(A)), and are thereby supplied to two channels of serially connected D flip-flop circuits 8A to 8M and 9A to 9M.

The D flip-flop circuits 8A to 8M and 9A to 9M are operable to transfer the data DG1 to DG8 sequentially in synchronism with a clock signal SCK2 (Figure 6(B)) whose frequency is that of the clock signal SCK divided by 2, and it is thereby possible to drive the D flip-flop circuits 8A to 8M and 9A to 9M at a low frequency and obtain data at this low frequency.

As a result, the consumed power can be reduced to a half corresponding to the arrangement using the clock signal SCK2 for the D flip-flop circuits 8A to 8M and 9A to 9M obtained by dividing the frequency of the clock signal SCK by 2.

However, even if such an arrangement is used, the instantaneous current cannot be reduced and there still remains a practical difficulty in providing the circuit elements in the form of an integrated circuit.

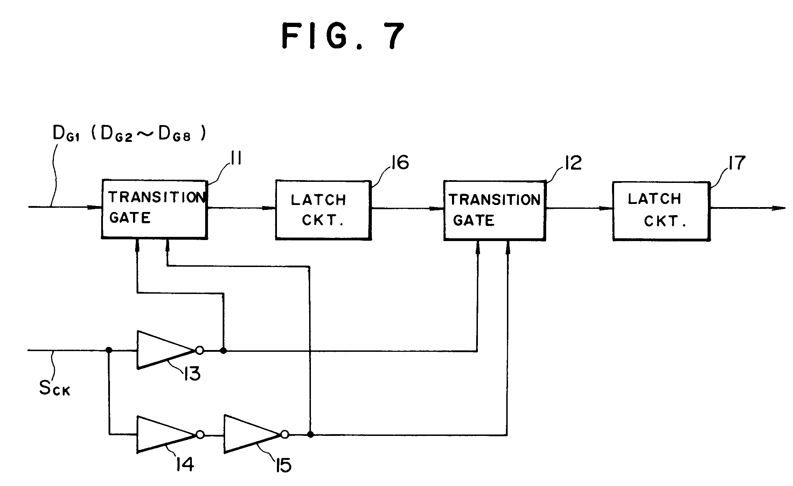

Further, as shown in Figure 7 of the accompanying drawings, the D flip-flop circuit of the above-described type is structured of transition gates 11 and 12 each being formed by two CMOS transistors, inverting amplifiers 13, 14 and 15, each similarly formed by two CMOS transistors, and latch circuits 16 and 17 each formed by four CMOS transistors, and therefore, eighteen transistors in all must be used in the circuit.

Hence, when 700 D flip-flop circuits are used for one bit as mentioned above, a hundred thousand transistors will be necessary for processing 8-bit image data. When these transistors are to be arranged on an integrated circuit, the area of one chip occupied by the D flip-flop circuits is large, and this has resulted in the problem of the overall size of the chip becoming large accordingly.

The following documents disclose various circuits having features similar to those set forth in the pre-characterising portion of claim 1: BBC Research Department Report, No. 5, July 1987, Tadworth, GB, pages 1-20, J L Riley "A review of the semiconductor storage of television signals"; Texas Instruments, Product Review TMS4464, 1984; Elektronik, Vol. 31, No. 15, July 1982, Munchen, DE, pages 27-30, P Mattos et al, "Nibble-Mode beschleunigt Speicherzugriff".

According to the present invention there is provided an input circuit comprising:
a first data line comprising a plurality of lines, and a second data line comprising N unit data lines, where N>1, each unit data line being formed of the same number of lines as the number of lines forming said first data line, wherein data is supplied from the first data line to the second data line; characterised by:
switch means respectively connecting said first data line with each of said unit data lines;
control means for controlling said switch means such that the switch means corresponding to respective unit data lines of said second data line are sequentially turned on in synchronism with a clock signal;
latch circuits provided between said switch means and respective unit data lines of said second data line; and
means (4A) for transferring data from the second data line at intervals of N times the period of the clock signal.

The input circuit may comprise a third data line formed of one line, and serial/parallel conversion means connecting said third data line with said first data line.

In this case, the third data line may be connected to an input protection circuit comprising an input terminal; a circuit ground terminal; an input protection resistor provided between the input terminal and the third data line; and a plurality of circuits connected in parallel between the third data line and the circuit ground terminal, each of the circuits comprising a MOS transistor and a resistor connected in series.

An input circuit according to a preferred embodiment of the present invention, to be described in greater detail hereinafter, is operable such that each of the unit data lines thereof is successively connected to said first data line, in synchronism with a clock signal, for input of data, and it is thereby made possible, when the circuit is formed into an integrated circuit, to produce one of small size, low power consumption and drawing a small instantaneous current. Moreover, the latch circuits enable data to be transferred from the second data line at intervals of N times the period of said clock signal, where N is the number of unit data lines, so that data can be converted to a still lower frequency.

The invention will now be described by way of example with reference to the accompanying drawings, throughout which like parts are referred to by like references, and in which:
Figure 1 is a block diagram showing a serial/parallel conversion circuit according to an embodiment of the present invention;
Figures 2(A) to 2(E) are signal waveform charts used for explaining operation of the circuit shown in Figure 1;
Figure 3 is a block diagram showing a memory circuit;
Figures 4 and 5 are block diagrams showing previously-proposed serial/parallel conversion circuits;
Figures 6A and 6B are signal waveform charts used for explaining operation of the circuit shown in Figure 5;
Figure 7 is a block diagram showing a D flip-flop circuit;
Figures 8(A) and 8(B) show an input protection circuit for use in embodiments of the present invention, of which Figure 8(A) is a circuit diagram and Figure 8(B) is a plan view of MOS transistors;
Figure 9 is a graph showing a breakdown characteristic; and
Figure 10 is a plan view of MOS transistors forming a further input protection circuit for use in embodiments of the present invention.

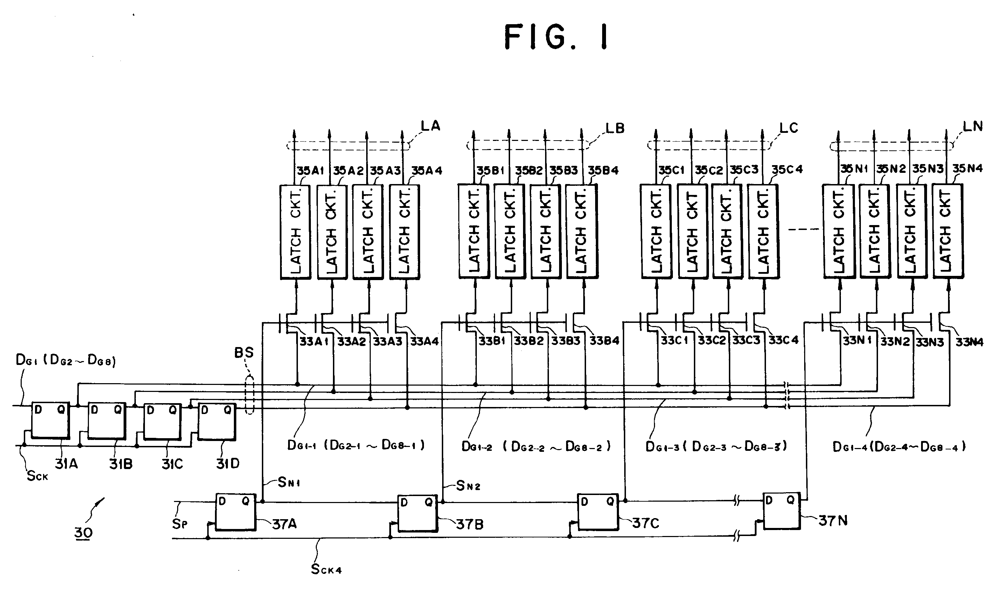

Referring to Figure 1, there is shown a serial/parallel conversion circuit 30 which is used in place of the serial/parallel conversion circuits 2A to 2H of Figure 4, thereby constituting an overall input circuit.

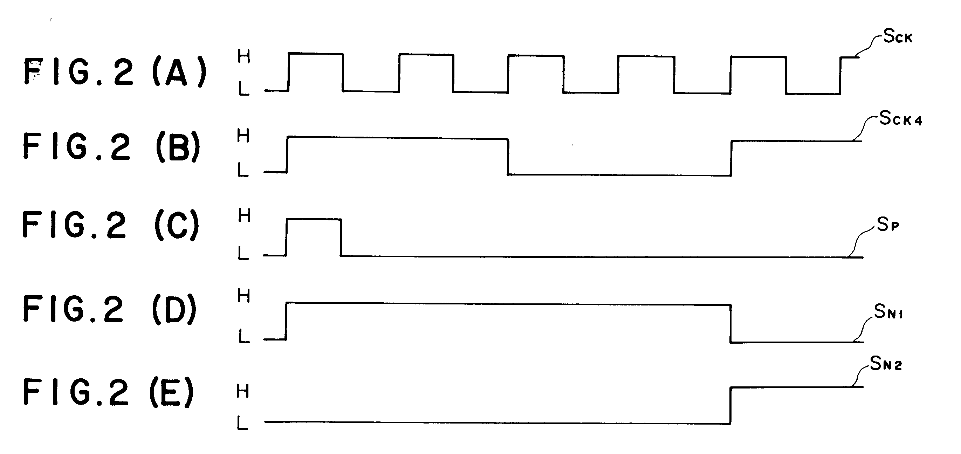

Four D flip-flop circuits 31A to 31D are connected in series so as to acquire data at a timing synchronised with a clock signal SCK (Figure 2(A)) of image data DG, data DG1 being supplied to the input of the D flip-flop circuit 31A.

Consequently, the data DG1 is sequentially transferred via adjoining D flip-flop circuits, from the D flip-flop circuit 31A at one end towards the D flip-flop circuit 31D at the other end, at the timing of the clock signal SCK, and output data DG1-1 to DG1-4 from the respective D flip-flop circuits 31A to 31D are supplied on four data bus lines BS.

Hence, by arranging that the data DG1-1 to DG1-4 are taken in at a low frequency corresponding to 1/4 of the clock signal SCK, it is possible to obtain parallel data converted from the data DG1 to DG8 at a low frequency which is 1/4 of the transfer rate of the image data DG.

In the present embodiment, the data DG1-1 to DG8-4 are further subjected to serial/parallel conversion processing and are thereby converted into data with a still lower frequency.

More particularly, N sets of D flip-flop circuits 37A to 37N are connected in series and are driven on the basis of a clock signal SCK4 (Figure 2(B)) having a frequency of 1/4 of the clock signal SCK, and further, a pointer signal SP (Figure 2(C)), which goes high at intervals of N periods of the clock signal SCK4 in synchronism with the clock signal SCK, is supplied to the D flip-flop circuit 37A at one end of the series.

The pointer signal SP is then sequentially transferred to the adjoining D flip-flop circuit at a timing synchronised with the clock signal SCK4, and thereby outputs SN1, SN2, ... (Figures 2(D) and 2(E)) of the D flip-flop circuits 37A to 37N are caused to go high sequentially in synchronism with the clock signal SCK4.

On the other hand, the four data bus lines BS are each connected with N gate circuits 33A1 to 33N4, and these gates are each arranged to open when the output of the corresponding one of the D flip-flop circuits 37A to 37N goes to the logic high "H" level.

Consequently, in accordance with the successive transfer of the pointer signal SP at the timing in synchronism with the clock signal SCK4, the N gate circuits 33A1 to 33N4 connected with each of the data bus lines BS are controlled such that only one set of the gate circuits 33A1 to 33N4 are sequentially turned on. Thus, the data DG1- 1 to DG1-4 supplied to their respective data bus lines BS are made sequentially obtainable from the gate circuits 33A1 to 33N4 at intervals of four periods of the clock signal SCK.

Hence, by arranging that the output data are taken in from each of groups of four of the gate circuits 33A1 to 33A4, 33B1 to 33B4, ... 33N1 to 33N4, which are connected respectively with the D flip-flop circuits 37A to 37N, it is possible to acquire the data DG1-1 to DG1-4, which are supplied to the data bus lines BS, at intervals of N times the period of the clock signal SCK4.

For that purpose, in the present embodiment, latch circuits 35A1 to 35N4 are used so that the data obtained through the respective gate circuits 33A1 to 33N4 are latched thereto and their output data are delivered to a memory block 4A (not shown in Figure 1) through bus lines LA, LB, LC, ... LN.

In this way, the period of the clock signal SCK4 can be set to four times the period of the clock signal SCK and the current consumption can be reduced accordingly.

Further, in the present case, the latch circuits 35A1 to 35N4 connected with the bus lines LA, LB, LC, ... LN and the gate circuits 33A1 to 33N4 can be structured by the latch circuit 16 or 17 and the transition gate 11 or 12 of the D flip-flop circuit shown in Figure 7.

Therefore, an input circuit capable of processing 8-bit image data can be structured of N sets by 1 system of D flip-flop circuits 37A to 37N and 4 sets of D flip-flop circuits 31A to 31D, and N sets by 8 systems of latch circuits 35A1 to 35N4 and gate circuits 33A1 to 33N4, each set thereof being made up of 6 transistors, and thus the instantaneous current can be reduced; when arranged in the form of an integrated circuit, the area on the chip occupied by these elements can accordingly be reduced.

Specifically, when it is intended to provide data with a repetition frequency which is the same as in the previously-proposed input circuit using 700 D flip-flop circuits, the number of transistors required can be reduced to approximately one half.

Thus, while the data bus lines BS constitute a first data line for receiving the image data DG through the D flip-flop circuits 31A to 31D, each of the bus lines LA, LB, LC, ... LN constitutes a unit data line made up of the same number of lines as that of the data bus lines BS, and the bus lines LA, LB, LC, ... LN as a whole constitute a second data line including a plurality of unit data lines.

Further, while the latch circuits 35A1 to 35N4 and the gate circuits 33A1 to 33N4 constitute switch means connecting the data bus lines BS with each of the bus lines LA, LB, LC, ... LN, the D flip-flop circuits 37A to 37N constitute control means for controlling the switch means such that one set each of the gate circuits 33A1 to 33N4 is sequentially turned on at intervals of the period of the data DG1-1 to DG8-4 input to the data bus lines BS.

According to the above-described arrangement, by changing over input data sequentially and cyclically with the use of the switching means and supplying the data to a plurality of bus lines, an input circuit having a lower repetition frequency and using a smaller number of transistors as a whole can be structured; thus, when the input circuit is arranged in the form of an integrated circuit, it is possible for this to be of a smaller size, consuming less power, and drawing a smaller instantaneous current than the previously-proposed circuit.

Although the above embodiment has been described relative to the case where the image data are transferred between the D flip-flop circuits 31A to 31D and the data were thereby switched over to the data bus lines BS bit by bit, the present invention is not limited to such an arrangement; by providing eight bus lines for the data bus line BS, 8-bit image data may be input directly to these bus lines.

Although the above embodiment has been described in the context of a memory circuit for image data, the present invention is equally applicable to memory circuits for various other types of data.

Further, the present invention is not only applicable to an input circuit for a memory circuit, but is also generally applicable to input circuits for various types of data processing circuits.

According to the preferred embodiment of the present invention as described above, data are sequentially input from a plurality of bus lines by arranging each set of gate circuits to be sequentially switched over, and thus, an input circuit having a low repetition frequency and using a smaller number of transistors overall can be provided such that, when arranged in the form of an integrated circuit, the circuit can be of smaller size, consuming less power and drawing a smaller instantaneous current.

Additionally, by using an input protection circuit as described below between an internal circuit including the above-described input circuit and the input terminal, thermal destruction of the internal circuit (especially, bypassing MOS transistors) due to abnormal voltages such as surge voltages can be effectively prevented.

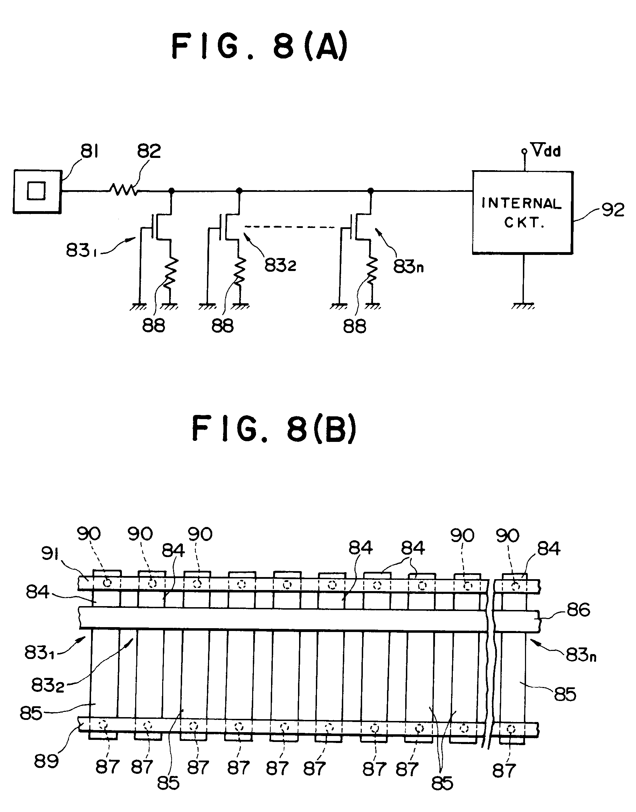

Figures 8(A) and 8(B) show an input protection circuit for use in an input circuit embodying the invention. Figure 8(A) is a circuit diagram of the input protection circuit and Figure 8(B) is a plan view of MOS transistors forming the circuit. The input protection circuit includes an input terminal 81 and an input protection resistor 82 having one end connected to the input terminal 81. MOS transistors 83₁, 83₂, ... 83ₙ (n represents the number, for example, of units, tens, or hundreds) have their drains 84 connected to the terminal of the input protection resistor 82 at the side opposite to the input terminal 81, while their sources 85 and common gate 86 are grounded. The sources 85 are elongate, as compared with the drains 84, along the length of the channel (the length from top to bottom in Figure 8(B)) and source electrodes 87 project from the end portions of the sources 85 at the side distant from the gate, whereby diffused resistors 88 are formed by source diffused layers at the side of the source. Source wiring 89 is grounded. Drain electrodes 90 are provided and drain wiring 91 is connected between the terminal of the input protection resistor 82 at the side opposite to the input terminal and the input of an internal circuit 92.

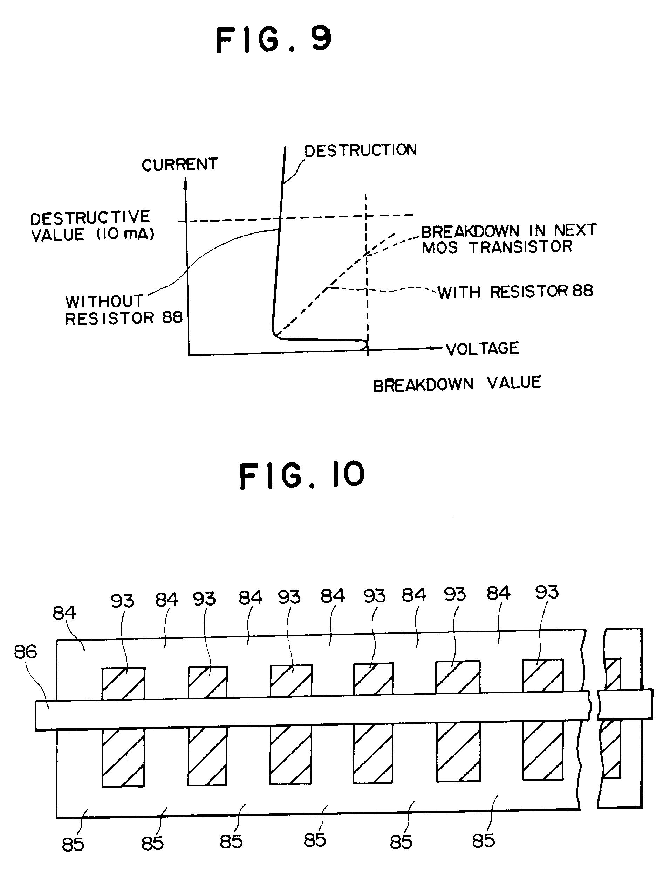

In the present input protection circuit, the MOS transistors 83₁, 83₂, ... 83ₙ are in an off state in the normal condition. When an abnormally high voltage such as a surge voltage is applied between the input terminal and the ground line, the abnormal voltage becomes impressed on all the MOS transistors 83₁ to 83ₙ through the resistors 88. Then, avalanche breakdown caused by the voltage occurs in all the MOS transistors 83₁ to 83ₙ, whereby the resulting current is caused to flow separately through each of the MOS transistors 83₁ to 83ₙ. At this time, concentration of the current onto a part is prevented by the presence of the resistors 88. Explanation of this effect will be given below with reference to Figure 9 which shows a breakdown characteristic.

When subjected to an abnormal voltage, a MOS transistor exhibits a voltage-current characteristic as indicated by a solid line in Figure 9. More particularly, when the abnormal voltage is applied, the terminal voltage increases until it reaches the breakdown voltage. Breakdown occurs at this point, and the current flowing at this time is virtually zero. The terminal voltage shows an immediate sharp drop to a low value, and thereafter, the current starts to increase steadily, while the terminal voltage exhibits virtually no change, until the current value exceeds the destructive value (for example, 10 mA), when destruction occurs. In the case of the present arrangement, however, since the resistor 88 is connected in series with any of the MOS transistors 83, the terminal voltage of the resistor 88 increases with the increase in the current following the sharp drop in the voltage due to the avalanche breakdown, this being shown by a broken line in Figure 9. Then, this increase in the terminal voltage leads to an increase in the terminal voltage of another MOS transistor 83, because the series circuits of the transistor and the resistor are all connected in parallel. Hence, before thermal destruction can be caused of the MOS transistor which has caused the avalanche breakdown, the terminal voltage of another MOS transistor 83 will exceed the breakdown value, whereby this MOS transistor may also cause breakdown and thereby this MOS transistor also conducts a current. In this manner, the MOS transistors 83 cause breakdown one after another, as in a chain reaction, allowing the current to flow therethrough. All such actions take place in a very short period of time, virtually instantaneously. Hence, all the MOS transistors 83 cause the avalanche breakdown almost simultaneously, whereby the current due to the abnormal voltage is caused to flow separately through all the MOS transistors 83. Thus, the internal circuit 93 can be protected from causing thermal destruction.

Figure 10 is a plan view showing another input protection circuit for use in input circuits embodying the invention. In this input protection circuit, the source and the drain of a plurality of MOS transistors are each formed of a diffused layer, and there are formed insulating films (LOCOS) 93, which traverse the gate 86 when viewed from above, so that each of the diffused layers is substantially separated into divisions, whereby a plurality of MOS transistors are substantially provided.

Although in the above described embodiments, the resistor 88 in series connection with each MOS transistor 83 is connected at the side of the source, it need not necessarily be connected that way but it can be connected at the opposite side, namely the side of the drain. Alternatively, resistors may be connected at both the drain side and the source side. The required effect is provided if one or more resistors 88 are connected in series with each of the MOS transistors 83.

In the above-described embodiments, the MOS transistors 83 are of the n-channel MOS type and hence the gate of each of the MOS transistors is grounded. In the case where transistors of the p-channel type are used, the gate of each of the MOS transistors will be connected with the power supply line (Vdd).

Although the above described embodiments are for protecting the internal circuit from an abnormal voltage applied between the input terminal 81 and ground, it is of course possible to use the input protection circuit for protecting the internal circuit from an abnormal voltage applied between the power supply line (Vdd) and the input terminal 81.

As described so far, the input protection circuit provides an input protection resistor between an input terminal and an internal circuit, a plurality of series circuits of a MOS transistor and a resistor are arranged in parallel and connected between the wiring connecting the input protection resistor with the internal circuit and a fixed-potential point, and a predetermined voltage is supplied to the gate of the MOS transistors.

Since the plural MOS transistors are each provided with a resistor connected in series, and such series circuits of the MOS transistor and the resistor are connected in parallel, concentration of the current onto a part can be prevented by each of the resistors, and it is thereby possible to have avalanche breakdown take place in each of the MOS transistors. Thus, destruction by heat due to current concentration can be prevented.

## Claims

1. An input circuit comprising:
a first data line (BS) comprising a plurality of lines, and a second data line (LA to LN) comprising N unit data lines (LA, LB ... LN), where N>1, each unit data line being formed of the same number of lines as the number of lines forming said first data line (BS), wherein data is supplied from the first data line (BS) to the second data line; characterised by:
switch means (33A1 to 33N4) respectively connecting said first data line (BS) with each of said unit data lines (LA to LN);
control means (37A to 37N) for controlling said switch means (33A1 to 33N4) such that the switch means corresponding to respective unit data lines (LA, LB ... LN) of said second data line are sequentially turned on in synchronism with a clock signal (SCK4);
latch circuits (35A1 to 35N4) provided between said switch means (33A1 to 33N4) and respective unit data lines (LA, LB ... LN) of said second data line (LA to LN); and
means (4A) for transferring data from the second data line (LA to LN) at intervals of N times the period of the clock signal (SCK4).

2. An input circuit according to claim 1 wherein said control means is formed by flip-flop circuits (37A to 37N).

3. An input circuit according to claim 1 or claim 2, including a third data line formed of one line, and serial/parallel conversion means (31A to 31D) connecting said third data line with said first data line (BS), wherein serial data supplied to said third data line is supplied to said second data line (LA to LN) via said first data line (BS) as a parallel input.

4. An input circuit according to claim 3, wherein said third data line is connected to an input protection circuit comprising:
an input terminal (81);
a circuit ground terminal;
an input protection resistor (82) provided between the input terminal (81) and the third data line; and
a plurality of circuits connected in parallel between the third data line and the circuit ground terminal, each of the circuits comprising a MOS transistor (83) and a resistor (88) connected in series.

## Patentansprüche

1. Eingangsschaltung, mit:
einer ersten Datenleitung (BS), die mehrere Leitungen aufweist, und einer zweiten Datenleitung (LA bis LN), die N Datenleitungseinheiten (LA, LB, ... LN) aufweist, wobei N > 1 ist, wobei jede Datenleitungseinheit aus der gleichen Anzahl von Leitungen besteht wie die Anzahl der Leitungen, die die erste Datenleitung (BS) bilden, wobei die Daten von der ersten Datenleitung (BS) zur zweiten Datenleitung geliefert werden; gekennzeichnet durch:
eine Schalteinrichtung (33A1 bis 33N4), die jeweils die erste Datenleitung (BS) mit jeder der Datenleitungseinheiten (LA bis LN) verbindet;
eine Steuereinrichtung (37A bis 37N) zum Steuern der Schalteinrichtung (33Al bis 33N4), so daß die Schalteinrichtung, die entsprechenden Datenleitungseinheiten (LA, LB, ... LN) der zweiten Datenleitung entspricht, synchron mit einem Taktsignal (SCK4) nacheinander eingeschaltet werden;
Latchschaltungen (35A1 bis 35N4), die zwischen der Schalteinrichtung (33Al bis 33N4) und den entsprechenden Datenleitungseinheiten (LA, LB, ... LN) der zweiten Datenleitung (LA bis LN) vorgesehen sind; und
eine Einrichtung (4A) zur Übertragung von Daten von der zweiten Datenleitung (LA bis LN) in Intervallen der N-fachen Periode des Taktsignals (SCK4).

2. Eingangsschaltung nach Anspruch 1, wobei die Steuereinrichtung durch Flip-Flop-Schaltungen (37A bis 37N) gebildet ist.

3. Eingangsschaltung nach Anspruch 1 oder 2, mit einer dritten Datenleitung, die aus einer Leitung besteht, und einer Seriell/Parallel-Umsetzungseinrichtung (31A bis 31D), die die dritte Datenleitung mit der ersten Datenleitung (BS) verbindet, wobei serielle Daten, die zur dritten Datenleitung geliefert werden, zur zweiten Datenleitung (LA bis LN) über die erste Datenleitung (BS) als eine parallele Eingabe geliefert werden.

4. Eingangsschaltung nach Anspruch 3, wobei die dritte Datenleitung mit einer Eingangsschutzschaltung verbunden ist, die aufweist:
einen Eingangsanschluß (81);
einen Schaltungs-Erdanschluß;
einen Eingangsschutzwiderstand (82), der zwischen dem Eingangsanschluß (81) und der dritten Datenleitung vorgesehen ist; und
mehrere Schaltungen, die parallel zwischen der dritten Datenleitung und dem Schaltungs-Erdanschluß geschaltet sind, wobei jede Schaltung einen MOS-Transistor (83) und einen in Reihe geschalteten Widerstand (88) aufweist.

## Revendications

1. Circuit d'entrée, comprenant:
- une première ligne de données (BS) comprenant une pluralité de lignes, et une deuxième ligne de données (LA à LN) comprenant N lignes de données unitaires (LA, LB, ..., LN), où N > 1, chaque ligne de données unitaires étant formée du même nombre de lignes que le nombre de lignes formant ladite première ligne de données (BS), dans lequel les données sont fournies de la première ligne de données (BS) à la deuxième ligne de données, caractérisé par:
- des moyens formant commutateur (33A1 à 33N4) connectant respectivement ladite première ligne de données (BS) à chacune desdites lignes de données unitaires (LA à LN);
- des moyens de commande (37A à 37N) pour commander lesdits moyens formant commutateur (33A1 à 33N4) de telle manière que les moyens formant commutateur correspondant aux lignes de données unitaires respectives (LA, LB, ..., LN) de ladite deuxième ligne de données soient rendus conducteurs séquentiellement en synchronisme avec un signal d'horloge (SCK4);
- des circuits à verrouillage (35A1 à 35N4) prévus entre lesdits moyens formant commutateur (33A1 à 33N4) et les lignes de données unitaires respectives (LA, LB, ..., LN) de ladite deuxième ligne de données (LA à LN); et
- des moyens pour transférer les données à partir de la deuxième ligne de données (LA à LN) à des intervalles de N fois la période du signal d'horloge (SCK4).

2. Circuit d'entrée selon la revendication 1, dans lequel lesdits moyens de commande sont formés par des circuits à bascule (37A à 37N).

3. Circuit d'entrée selon la revendication 1 ou la revendication 2, comportant une troisième ligne de données formée d'une d'une ligne, et des moyens de conversion série/parallèle (31A à 31D) connectant ladite troisième ligne de données à ladite première ligne de données (BS), dans lequel les données série fournies à ladite troisième ligne de données sont fournies à ladite deuxième ligne de données (LA à LN) par l'intermédiaire de ladite première ligne de données (BS) sous la forme d'un signal d'entrée parallèle.

4. Circuit d'entrée selon la revendication 3, dans lequel ladite troisième ligne de données est connectée à un circuit de protection d'entrée comprenant:
- une borne d'entrée (81);
- une borne de masse du circuit;
- une résistance de protection d'entrée (82) montée entre la borne d'entrée (81) et la troisième ligne de données; et
- une pluralité de circuits montés en parallèle entre la troisième ligne de données et la borne de masse du circuit, chacun des circuits comprenant un transistor MOS (83) et une résistance (88) montés en série.
